Europäisches Patentamt

**European Patent Office**

Office européen des brevets

(19)

(11) Publication number: **0 058 464**
**A1**

(12) # EUROPEAN PATENT APPLICATION

(21) Application number: **82300038.5**

(22) Date of filing: **05.01.82**

(51) Int. Cl.³: **G 01 R 19/165**

(30) Priority: **09.01.81 GB 8100623**

(43) Date of publication of application:
**25.08.82 Bulletin 82/34**

(84) Designated Contracting States:
**AT BE CH DE FR IT LI NL SE**

(71) Applicant: WESTINGHOUSE BRAKE AND SIGNAL
COMPANY LIMITED
Foundry Lane
Chippenham Wiltshire SN15 1RT(GB)

(72) Inventor: Brown, Christopher Robert Westinghouse
Brake
& Signal Co. Ltd. Westinghouse Signals P.O. Box 79
Chippenham Wilts., SN15 1JD(GB)

(72) Inventor: Corrie, John Douglas Westinghouse Brake
& Signal Westinghouse Signals Co. Ltd. P.O. Box 79
Chippenham Wilts., SN15 1JD(GB)

(74) Representative: Page, Edmund John
PAGE & CO P.O. Box 113 Foundry Lane
Chippenham Wiltshire SN15 1EW(GB)

(54) Current steering circuit.

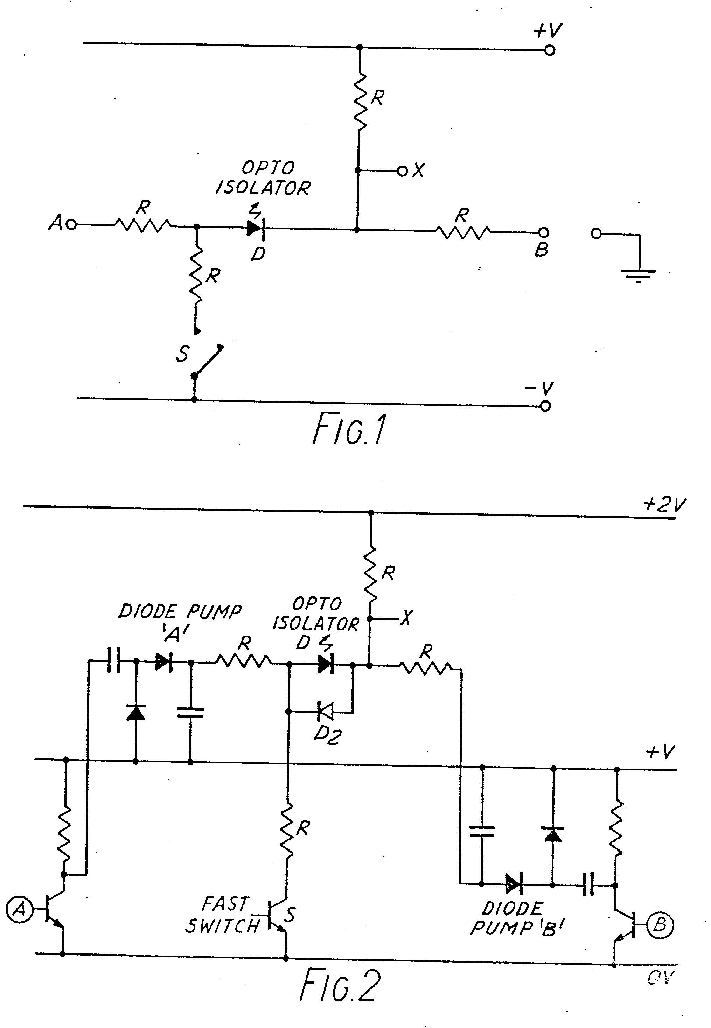

(57) A current steering circuit for comparing the outputs of
two channels of a parallel redundant control system. The
voltages and senses of the outputs are mirror-images and
are fed into opposite ends (A;B) of four terminal resistor
network (Fig 1), of two bias arms (R) and two input arms (R),
at the centre junction of which is a light emitting diode (D).
One of the bias arms contains oscillating switch means (S)
which causes the diode (D) bias voltage to oscillate. When
the input voltage at the diode cathode is high the diode will
emit light and the voltage at the diode anode will oscillate
across a predetermined threshold voltage only when the
inputs agree. Two or more circuits can be connected
together to compare the outputs of several parallel redun-
dant channel.

FIG.1

EP 0 058 464 A1

Current Steering Circuit

The invention relates to a current steering circuit.

The invention will find particular application in parallel redundant control systems for comparing the outputs of the constituent sub-systems or channels and producing therefrom a single control output upon which the sub-systems or channels agree.

Such comparison means are preferably fail-safe in their operation, that is they should provide or indicate a predetermined output state in the event of any abnormality which in this instance includes disagreement between the sub-systems or channels as well as malfunction of the circuit itself.

Acheivement of fail-safe equipment and circuits by adopting robust designs and fault tolerance analysis precludes the application of much advanced technology from use in safe applications. Increasing consideration is being given to redundancy and diversity techniques where a number of non-fail-safe systems are used in parallel because it is unlikely that they will all go wrong in the same way at the same time. An important part of any such system is the voting circuit which decides, from comparing the output of all the systems, what action it is safe to effect. The voter must be fail-safe and early designs used safety relays, thus reducing the quantity of safe relays in a safe system but not eliminating them.

According to the present invention there is provided a current steering circuit for comparing two digital signals the levels and senses of which are mirror-images comprising a four terminal network having two input terminals, two voltage supply terminals and a resistive arm connected to each of the terminals in which the arms from a first of the input and a first of the supply terminals lead  to a first junction and the arms from the second input and second supply terminals lead to a second junction, a diode connected between said first and second junctions, switching means in the first resistive arm from the first junction on one side of the diode to the first supply terminal which is operative to alternatively connect and disconnect the voltage supply and a voltage monitor point on the opposite side of the diode at the second junction so that, in use and with the switching means operating, current through the diode will indicate the sense of the digital signal at the first input terminal and the voltage at the monitor point will indicate whether or not the signal at the second input terminal is in agreement being an alternating signal at the switching frequency and crossing a threshhold voltage only when the input signals are mirror images of each other.

In a control system comprising two parallel sub-systems or channels a signal for the first input terminal is provided by the output of one channel and a signal for the second input terminal by the output of the other channel. Where there are more than two sub-systems or channels all the combinations of two outputs are compared by separate steering circuits the outputs of which feed in parallel into a single control output.

Where each sub-system or channel generates control signals for a multiplicity of functions, each function has dedicated to it a commensurate number of steering circuits for comparing or voting on the sub-system or channel outputs. Where said control signals are serially multiplexed the control signals are appropriately routed to the individual steering circuits.

For a better understanding of the present invention and to show how the same may be carried into effect, reference will now be made, by way of example, to the accompanying drawings in which:

Fig. 1 illustrates the basic principle of a current steering logic circuit,

Fig. 2 shows a practical design of current steering logic circuit, for two logic inputs,

Fig. 3 shows the manner of cascading circuits for a multiplicity of controls from two parallel channels,

Fig. 4 illustrates how the signals for one function are compared in a three channel system, and

Fig. 5 illustrates a logic circuit for control of power in a three channel system.

Referring now to the drawings, there is shown in Fig. 1 a current steering logic circuit having two inputs A and B to which two devices A and B in a diversity system are respectively connected, i.e. in which two channels must agree.

The circuit of Fig. 1 comprises a pair of input terminals, A and B, and a pair of voltage supply terminals, +V and -V. Four equal resistors R are connected in a star-like configuration to these four terminals in which is also included a diode D connected between a first junction, of the resistors to input A and supply line -V, and a second junction, of the resistors to input B and supply line +V. A switching means S is connected between one end of the corresponding resistor and the supply line -V, and thus is on one side of the diode D, a voltage monitor point X is provided at a second resistor junction on the other side of the diode. The senses of the signals connected to A and B are mirror-images of each other i.e. devices A and B are arranged to operate in opposite senses, so that the "proceed" state of A is towards +V volts with respect to 0 volts and the "proceed" state of B is towards -V volts with respect to 0 volts. The "do not proceed" state of both devices A and B is 0 volts.

It will be understood that it can easily be shown that in the circuit of Fig. 1 if A = B (i.e. both devices say "proceed" or both say "do not proceed"), and the switch S is closed then point X will be at 0 volts. If, the switch is open the voltage at X will rise to $+\frac{1}{3}V$. Hence, if A and B agree point X may be observed to switch between $+\frac{1}{3}V$ and 0 volts. If A says "proceed" and B says "do not proceed" (A = +V; B = 0 volts) then point X switches between $+\frac{2}{3}V$ and $+\frac{1}{4}V$. If A says "do not proceed" and B says "proceed" (A = 0 volts; B = -V) then point X switches between 0 volts and $-\frac{1}{4}V$. Hence, if point X is compared with a threshhold of $+\frac{1}{8}V$, then X will only be observed to change a state, as the switch S operates, if A and B agree.

The optical isolator diode D turns on and off as the switch operates if A says "proceed" (+V) but remains off if A says "do not proceed". Therefore the circuit may be used to provide switching outputs to a "proceed" indicator e.g. a railway signal, and also a switching output which shows that the two devices of the diversity system agree. External circuitry (not shown) may be used to disable A when X ceases to cross the $\frac{1}{8}V$ threshhold then, no proceed signal will be maintained, if A and B cease to agree.

Referring now to the circuit of Fig. 2, in which like parts have like references. An anti-parallel diode $D_2$ is connected across optical isolator diode D to maintain bias current in a practical circuit embodying the principles of Fig. 1. In this A is an output of one computer and B is an output of another computer which both contain the same program and observe the same process conditions for their inputs. If they wish to indicate a "proceed" state the computers cause their outputs to switch i.e. alternate at a low rate, and a "do not proceed" state is indicated by steady outputs. Respective diode pump circuits are used to convert the slow switching rates to d.c., diode pump A pumping above +V and diode pump B pumping below +V. The layout of the circuitry ensures that the +2V supply is not close to the diode pump A so that false "proceed" indications will not be maintained. A short circuit to B cannot forward bias the optical isolator's diode D and cannot therefore produce a proceed state. Filters (not shown) can be connected to the opto-isolator's output differentiate between switching at the fast switch rate and at the slow computer rate. Alternatively the switch rate may be slow, the computer's output rate fast and, opposite sense frequency discrimination used.

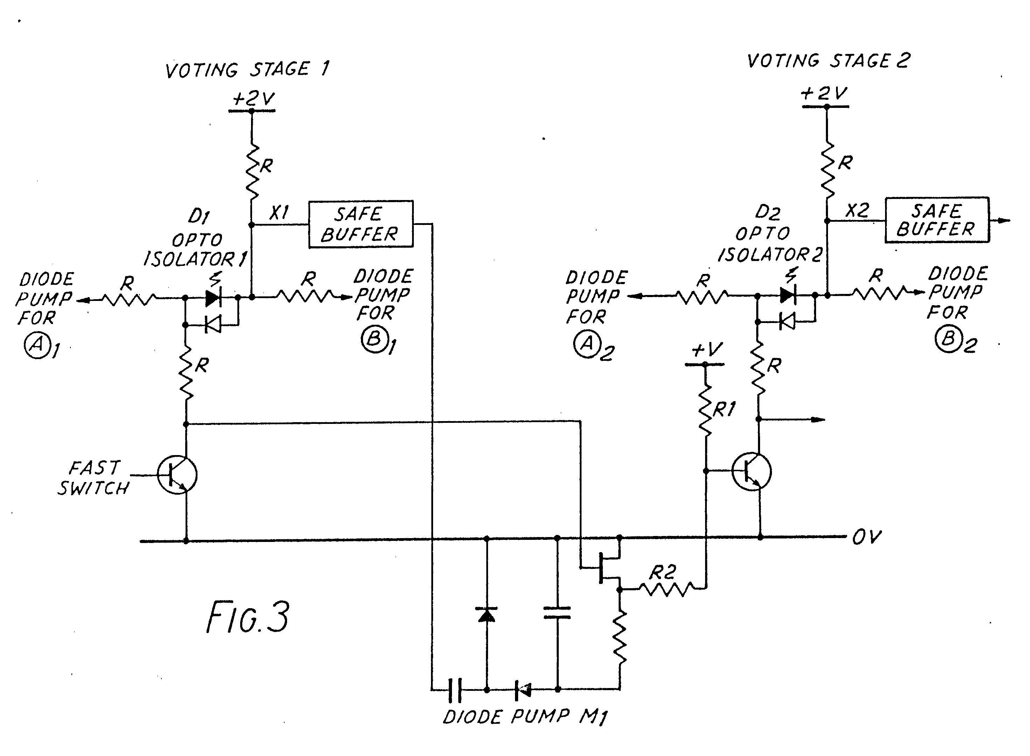

The arrangement shown in Fig. 3 is applicable to a system of two parallel sub-system or channels controlling a multiplicity of functions. In this each function has a steering dedicated to it which receives at its signal input terminals the appropriate output of each channel: the serial to parallel demultiplexing circuits are not shown. The control signal outputs agreed upon by both channels are derived from the optical isolators $D_1$, $D_2$.....etc; the signals from $X_1$, $X_2$....etc., signifying that the two channels have agreed upon each function signal, are cascaded. Thus, if the channels disagree on any of the functions the cascade chain is broken. A power supply maintaining circuit is connected to the end of the cascade chain, in its simplest form this is a normally open relay energised by the cascaded switching signal, so that, when the chain is broken the relay is released and the power supply to at least one of the control channels is cut-off.

In Fig. 3 the X output of one voting stage is used to charge a diode pump M negatively from 0 volts. The switch waveform fed into the first steering circuit from an external clock source (not shown) an FET biased by this negative voltage. Hence, if A and B agree the switching rate is passed through a number of voting stages, if A and B disagree the switching waveform is not passed to further circuits. Preferably, R2 is a resistor of the type the value of which cannot decrease, hence the switching transistor of voting circuit 2 cannot be turned off unless M is negative. If R1 goes open circuit then the switching transistor for voting stage 2 will not switch on so no fault can be dormant. The diode pump M provides the bias during any brief period of disagreement such as when A and B change state.

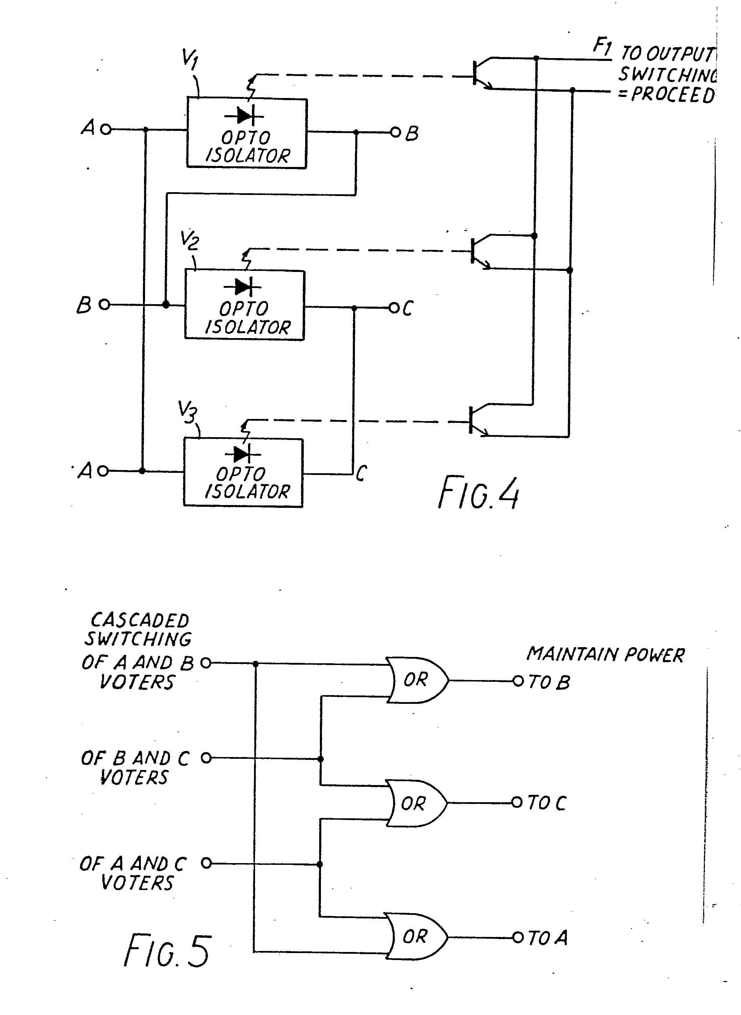

In applications where high availability is required a third computer C may be used in a redundant configuration and any two computers agreeing are sufficient to continue the control process, and any one of the three computers failing has its power removed until it has been repaired. Three steering circuits $V_1$, $V_2$ and $V_3$ are connected to compare the three combinations of two-out-of-three channel outputs as indicated in Fig. 4. The signals derived from each of the three optical-isolator outputs are connected in parallel. As shown in the drawing photo-sensitive transistors $T_1$, $T_2$ and $T_3$, responsive to respective light emitting diodes $D_1$, $D_2$ and $D_3$, have their collectors and emitters connected to the same pair of signals lines $F_1$ and arranged so that when at least one transistor is stimulated by received light to conduct current sufficient signal current flows through the signal lines $F_1$ which control the first function. The arrangement is repeated for a further function controlled by dedicated signal lines $F_n$. Provided that the switching waveforms used in all voting stages are synchronised then the output transistors of the optical isolators may be connected in parallel.

The cascaded switching lines may be gated in safe OR gates to control the power to the computers as shown in Fig. 5, the power being maintained to a computer while all its outputs agree with all the respective outputs of at least one other computer. When one of the channels A, B or C produces an erroneous output, since it will disagree with the other two channels, two of the cascaded chains will be broken so that one of the OR gates will not receive an "agreed" signal at either of its inputs. Hence its output will change state and remove an energising signal from, say, a power supply main training relay for the corresponding channel or sub-system. Preferably this relay de-energisation raises an appropriate alarm indicating a channel failure and alerting a technician to undertake remedial action. De-energisation of a channel is described as an example of one method of generally removing an erroneous channel output, other methods equally effective may be similarly controlled.

A control system of the type herein described may be used, inter alia, as a railway control signal interlocking system, in which the controlled functions are the states of the traffic control on wayside devices.

1. A current steering circuit for comparing two digital signals the levels and senses of which are mirror-images comprising a four terminal network having two input terminals (A; B), two voltage supply terminals (+V; -V) and a resistive arm (R) connected to each of the terminals in which the arms from a first of the input (A) and a first of the supply terminals (-V) lead to a first junction and the arms from the second input (B) and second supply terminals (+V) lead to a second junction, a diode (D) connected between said first and second junctions, switching means (S) in the first resistive arm (R) from the first junction on one side of the diode (D) to the first supply terminal (-V) which is operative to alternatively connect and disconnect the voltage supply and a voltage monitor point (X) on the opposite side of the diode at the second junction so that, in use and with the switching means (S) operating, current through the diode (D) will indicate the sense of the digital signal at the first input terminal (A) and the voltage at the monitor point (X) will indicate whether or not the signal at the second input terminal (B) is in agreement being an alternative signal at the switch-in frequency and crossing a threshold voltage only when the input signals are mirror images of each other.

2. A current steering circuit according to Claim 1 wherein the diode (D) is of the light emitting type.

3.  A current steering circuit according to either
Claim 1 or Claim 2 wherein the input terminal
(A;B) is connected to the resistive arm (R) through
a diode pump circuit ('A'; 'B') whereby to permit
operation with alternating input signals.

4.  A control system including two parallel sub-
systems each generating normally identical control
signals wherein said control signal from one system
is connected to the first input terminal (A) of a
current steering circuit according to any preceding
claim and the control signal from the second system
is connected to the second input terminal (B) and a
single combined control signal ($F_1$; Fig 4) is
derived from the current through the diode (D) and
the voltage at the monitor point (X) is connected to
actuate means for removing the output of one of the
control systems if the two systems do not agree.

5.  A control system including three parallel
sub-systems each generating normally identical
control signals wherein each of the three
combinations of two-out-of-three signals from said
sub-systems is compared by means of a current
steering circuit ($V_1$; $V_2$; $V_3$: Fig 4) according
to any of Claims 1 to 3 and wherein the outputs
from said steering circuits ($V_1$; $V_2$; $V_3$) are
connected in parallel to feed a single output ($F_1$)

and the monitor point voltages are compared by means
of logic gating (Fig 5) to actuate means for removing
the output of a sub-system which disagrees with the
other two sub-systems.

6. A control system according to any of claims 4 or 5
wherein each sub-system produces a multiplicity of
multiplexed outputs $(A_1; A_2;...B_1; B_2...;$ Fig 3) each
of which controls a different function by means of
signals derived from a dedicated current steering
circuit according to any of claims 1 or 3, the
multiplexed signals being switched to appropriate
steering circuits for comparison and wherein the
voltage monitor point $(X_1)$ of a first of the circuits
(Voting Stage 1) is connected to operate the switching
means (S) of a second of the circuits, and the remain-
ing monitor points $(X_2...)$ and switching controls are
cascaded in like fashion and the last monitor point
voltage is compared by means of logic gating to actuate
means for removing the output of a sub-system which
disagrees with the other two sub-systems.

FIG.1

FIG.2

FIG.3

VOTING STAGE 1

VOTING STAGE 2

DIODE PUMP FOR $A_1$

DIODE PUMP FOR $B_1$

DIODE PUMP FOR $A_2$

DIODE PUMP FOR $B_2$

DIODE PUMP $M_1$

FAST SWITCH

SAFE BUFFER

D1 OPTO ISOLATOR 1

D2 OPTO ISOLATOR 2

2/3

0058464

FIG.4

FIG.5

## DOCUMENTS CONSIDERED TO BE RELEVANT

| Category | Citation of document with indication, where appropriate, of relevant passages | Relevant to claim |
|---|---|---|
| A | <u>DE - B - 1 513 297</u> (LICENTIA)<br>* Column 2, line 54 - column 3, line 30; column 3, line 53 - column 5, line 34; fig. 1 *<br><br>-- | 1,3,4 |
| A | <u>DE - A - 2 133 457</u> (BBC)<br>* Page 3, line 7 - page 6, line 32; fig. 1 *<br><br>-- | 1,3 |
| A | <u>US - A - 3 825 682</u> (PHILLIPS)<br>* Abstract; column 2, line 5 - column 3, line 21; fig. 2 *<br><br>-- | 1 |
| A | <u>DE - A - 2 146 196</u> (ELLIOT)<br>* Page 7, line 5 - page 10, line 7; fig. 1 *<br><br>---- | 5,6 |

**CLASSIFICATION OF THE APPLICATION (Int. Cl. ³)**

G 01 R 19/165

**TECHNICAL FIELDS SEARCHED (Int.Cl. ³)**

B 61 L 1/00
B 61 L 7/00
G 01 R 19/00
G 05 B 9/00
G 05 B 23/00
G 06 F 11/00
H 03 K 5/00
H 03 K 13/00
H 03 K 19/00
H 04 B 17/00
H 04 L 1/24

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons
&: member of the same patent family, corresponding document

| X | The present search report has been drawn up for all claims | | |
|---|---|---|---|
| Place of search<br>VIENNA | Date of completion of the search<br>16-04-1982 | Examiner<br>KUNZE | |